(19) **Europäisches Patentamt / European Patent Office / Office européen des brevets**

(11) **EP 2 820 347 B1**

(12) **FASCICULE DE BREVET EUROPÉEN**

(45) Date de publication et mention de la délivrance du brevet:
**29.08.2018 Bulletin 2018/35**

(21) Numéro de dépôt: **13712847.6**

(22) Date de dépôt: **26.02.2013**

(51) Int Cl.:
*F21S 2/00* (2016.01)     *F21V 33/00* (2006.01)
*H01L 51/52* (2006.01)     *F21Y 115/15* (2016.01)

(86) Numéro de dépôt international:
**PCT/FR2013/050387**

(87) Numéro de publication internationale:
**WO 2013/128108 (06.09.2013 Gazette 2013/36)**

(54) **PANNEAU LUMINEUX ET PAROI DE BATIMENT**

LICHTTAFEL UND GEBÄUDEWAND

LIGHT PANEL AND BUILDING WALL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.02.2012  FR 1251857**

(43) Date de publication de la demande:
**07.01.2015  Bulletin 2015/02**

(73) Titulaire: **Saint-Gobain Placo**
**92150 Suresnes (FR)**

(72) Inventeurs:
 • **SARRANT-FORESTI, Maud**
  **F-75010 Paris (FR)**

 • **GUERING, Paul-Henri**
  **F-75013 Paris (FR)**
 • **BENKEMOUN, Yves**
  **F-78670 Villennes Sur Seine (FR)**

(74) Mandataire: **Saint-Gobain Recherche Département Propriété Industrielle 39 Quai Lucien Lefranc 93300 Aubervilliers (FR)**

(56) Documents cités:
**EP-A1- 1 596 638       EP-A2- 1 534 049**
**WO-A1-2009/087585    WO-A1-2010/032596**
**WO-A1-2010/129717    JP-A- 2009 259 559**
**US-A1- 2008 232 093**

**Description**

La présente invention a trait à un panneau lumineux et à une paroi de bâtiment comprenant un tel panneau lumineux, notamment en tant qu'élément structurel de la paroi. En particulier, le panneau lumineux peut être mis en oeuvre en tant que plaque de parement d'une cloison murale ou d'un plafond.

Il est connu de réaliser des luminaires de petite dimension à partir de diodes électroluminescentes organiques (OLED), qui sont aptes à convertir de l'énergie électrique en un rayonnement. Un élément fonctionnel OLED comprend un empilement de couches organiques électroluminescentes intercalé entre deux contacts électriquement conducteurs formant des électrodes avant et arrière. Un élément fonctionnel OLED est classiquement encapsulé entre deux substrats de protection, avant et arrière, de manière à former un dispositif OLED. Au moins l'électrode avant de l'OLED est transparente, de même que le substrat de protection avant, afin de permettre la sortie du rayonnement émis par l'empilement de couches électroluminescentes à travers la face avant du dispositif OLED. L'électrode transparente peut notamment être formée à base d'une couche d'oxyde conducteur transparent (Transparent Conductive Oxide ou TCO) ou à base d'une couche métallique transparente. Les substrats de protection avant et arrière peuvent notamment être constitués en verre ou en matériau organique polymère, rigide ou flexible. Un dispositif OLED flexible, dans lequel l'OLED est encapsulée avec des substrats polymères flexibles plutôt que des substrats rigides, a l'avantage d'être mince, pliable et léger.

Un dispositif OLED rigide ou flexible peut être associé, par exemple par collage, avec un support en forme de plaque de manière à former une plaque lumineuse. La plaque lumineuse peut être obtenue en recouvrant le support avec un dispositif OLED unique ou, lorsque les dimensions souhaitées de la surface lumineuse sur le support excèdent les dimensions disponibles de dispositifs OLED, en recouvrant le support avec une pluralité de dispositifs OLED juxtaposés. De manière avantageuse, le support utilisé pour former la plaque lumineuse est un élément structurel d'une paroi de bâtiment, tel qu'une plaque de parement pour une cloison ou un plafond. Il est alors possible, en positionnant plusieurs plaques lumineuses dans un système d'ossature classique de cloison ou de plafond, d'obtenir une paroi lumineuse de grande dimension pouvant jouer un double rôle de paroi et de luminaire.

Toutefois, dans une telle paroi lumineuse, il existe une discontinuité d'aspect à chaque zone de jonction entre deux plaques lumineuses juxtaposées, ce qui correspond à l'emplacement habituel des systèmes de jointoiement entre deux plaques de parement. Dans le cas où une plaque lumineuse est obtenue en juxtaposant une pluralité de dispositifs OLED sur une face d'un support, il existe également une discontinuité d'aspect à chaque zone de jonction entre deux dispositifs OLED juxtaposés sur le support. Ces discontinuités d'aspect se manifestent, en particulier à l'état allumé de la paroi lumineuse, par la présence de bandes sombres intermédiaires, non émissives de lumière, qui dégradent l'aspect visuel de la paroi

Le document EP 1 534 049 A2 décrit un luminaire selon le préambule de la revendication 1. Le document WO 2009/087585 A1 décrit des dalles lumineuses comportant des OLED et qui peuvent montées sur un panneau arrière.

Le document EP 1 596 638 A1 décrit un appareil d'éclairage destiné à être utilisé pour le rétroéclairage d'un écran à cristaux liquides. C'est à ces inconvénients qu'entend plus particulièrement remédier l'invention en proposant un panneau lumineux, destiné notamment à être intégré dans une paroi de bâtiment, qui présente un aspect visuel amélioré à la fois à l'état éteint et à l'état allumé du panneau.

A cet effet, l'invention a pour objet un panneau lumineux comprenant au moins deux dispositifs OLED juxtaposés qui forment une face avant du panneau lumineux et définissent deux zones émissives de lumière séparées par une zone intermédiaire, caractérisé en ce que chaque dispositif OLED est assemblé avec un élément structurel d'une paroi de bâtiment, notamment une plaque de parement de mur ou de plafond, le panneau lumineux comprenant des moyens formant joint lumineux qui assurent, à l'état allumé des deux dispositifs OLED, une continuité d'aspect entre la zone intermédiaire et les deux zones émissives, les moyens formant joint lumineux étant situés à l'arrière de, ou en affleurement avec, la face avant du panneau lumineux.

Dans le cadre de l'invention, un sens allant de l'arrière vers l'avant du panneau lumineux est défini comme allant dans la direction d'émission des dispositifs OLED. Ainsi, un premier élément est situé à l'arrière d'un deuxième élément lorsque le trajet du premier élément vers le deuxième élément a une composante qui va dans la direction d'émission des dispositifs OLED. Par ailleurs, au sens de l'invention, un élément est en affleurement avec la face avant du panneau lumineux lorsqu'il présente une surépaisseur, par rapport à cette face, inférieure ou égale à 2 mm, de préférence inférieure ou égale à 1 mm, encore de préférence inférieure ou égale à 0,5 mm et encore plus préférentiellement nulle.

De préférence, les moyens formant joint lumineux sont positionnés dans l'épaisseur du panneau lumineux. Selon l'invention, chaque dispositif OLED est assemblé avec un élément structurel d'une paroi de bâtiment, notamment une plaque de parement de mur ou de plafond, de sorte que le panneau lumineux peut être positionné directement dans un système d'ossature classique de mur ou de plafond. Cela permet, en particulier, d'obtenir de manière aisée une paroi lumineuse de grande dimension pouvant jouer un double rôle de paroi et de luminaire.

Selon d'autres caractéristiques avantageuses et non obligatoires de l'invention, prises isolément ou selon toutes les combinaisons techniquement possibles :

◦ A l'état allumé des deux dispositifs OLED, l'écart relatif de luminance $\Delta L/L_m$ entre la zone intermédiaire et chacune des deux zones émissives est inférieure à 10%, de préférence inférieure à 5%, encore de préférence inférieure à 1%. L'écart relatif de luminance est défini comme le rapport $\Delta L/L_m$, avec $\Delta L$ la différence de luminance moyenne entre les deux zones pour une consigne en intensité donnée de valeur non nulle, et $L_m$ la luminance moyenne de chaque zone émissive pour ladite consigne en intensité donnée. La luminance moyenne considérée à l'état allumé est celle du système de coordonnées colorimétriques CIE (L, u', v'). En effet, le système colorimétrique CIE (L, u', v') présente, par rapport au système colorimétrique CIE (L, x, y), un avantage de meilleure uniformité. Le système (L, u', v') est de ce fait mieux adapté pour l'évaluation des différences de couleurs entre deux zones à l'état allumé, qui se comportent comme deux sources primaires.

◦ A l'état allumé des deux dispositifs OLED, les coordonnées colorimétriques (u', v') de la zone intermédiaire sont à l'intérieur de l'ellipse de Mac Adam centrée sur les coordonnées colorimétriques (u', v') de chacune des deux zones émissives. L'utilisation des ellipses de Mac Adam est pertinente pour mesurer l'écart perceptible entre deux couleurs à l'état allumé. L'équation de ces ellipses est de la forme $ds^2 = g_{11} \Delta u'^2 + 2 g_{12} \Delta u'\Delta v' + g_{22} \Delta v'^2$, où les paramètres $g_{11}$, $g_{12}$ et $g_{22}$ sont déterminés de manière classique par application des résultats des travaux initiaux de Mac Adam (J.Opt.Soc.Am., 32,247-274, 1942 et J.Opt.Soc.Am., 39,808-834, 1949).

◦ La largeur maximale de la zone intermédiaire, prise perpendiculairement aux bords adjacents des deux zones émissives, est inférieure ou égale à 2 cm, de préférence inférieure ou égale à 1 cm, encore de préférence inférieure ou égale à 0,5 cm.

◦ Le panneau lumineux comprend un revêtement de la zone intermédiaire de telle sorte qu'à l'état éteint des deux dispositifs OLED, il existe une continuité d'aspect entre la zone intermédiaire et les deux zones émissives.

◦ A l'état éteint des deux dispositifs OLED, l'écart relatif de luminance $\Delta L/L_m$ entre la zone intermédiaire et chacune des deux zones émissives est inférieure à 10%, de préférence inférieure à 5%, encore de préférence inférieure à 1%. L'écart relatif de luminance est défini comme le rapport $\Delta L/L_m$, avec $\Delta L$ la différence de luminance moyenne entre les deux zones pour une consigne en intensité de valeur nulle, et $L_m$ la luminance moyenne de chaque zone émissive pour ladite consigne en intensité de valeur nulle. La luminance moyenne considérée à l'état éteint est celle du système de coordonnées colorimétriques CIE (L, a*, b*). En effet, à l'état éteint, les deux zones se comportent comme des sources secondaires, qui réémettent une partie du flux ambiant. Le système (L, a*, b*) est bien adapté pour l'évaluation des différences de couleurs entre deux sources secondaires.

◦ A l'état éteint des deux dispositifs OLED, la différence colorimétrique $\Delta E$ entre la zone intermédiaire et chacune des deux zones émissives est inférieure à 2, de préférence inférieure à 1. A l'état éteint, la différence colorimétrique $\Delta E$ entre deux zones est définie par l'expression (1) suivante utilisant le système de coordonnées colorimétriques CIE (L, a*, b*) :

$$\Delta E = \sqrt{(\Delta L)^2 + (\Delta a^*)^2 + (\Delta b^*)^2} \qquad (1),$$

avec

$\Delta L$     la différence de luminance moyenne entre les deux zones pour une consigne en intensité de valeur nulle,

$\Delta a^*$     la différence de la grandeur colorimétrique a* entre les deux zones pour ladite consigne en intensité de valeur nulle,

$\Delta b^*$     la différence de la grandeur colorimétrique b* entre les deux zones pour ladite consigne en intensité de valeur nulle.

◦ Dans un premier mode de réalisation, le panneau lumineux comprend un support, notamment une plaque de parement de cloison ou de plafond, sur une face duquel les deux dispositifs OLED sont juxtaposés.

◦ Dans un deuxième mode de réalisation, le panneau lumineux comprend deux supports juxtaposés, notamment deux plaques de parement de cloison ou de plafond, chaque support étant revêtu de l'un des deux dispositifs OLED.

◦ Dans les deux modes de réalisation ci-dessus, les moyens formant joint lumineux peuvent être solidaires d'au moins un support de dispositif OLED.

◦ En variante, dans le deuxième mode de réalisation ci-dessus, où le panneau lumineux comprend deux supports juxtaposés revêtus chacun de l'un des deux dispositifs OLED, les moyens formant joint lumineux peuvent être solidaires d'un élément d'ossature assurant la fixation d'un ou de chaque support de dispositif OLED sur une structure porteuse supportant le panneau lumineux. L'élément d'ossature peut être situé à l'arrière des supports de dispositif OLED ou être situé à l'avant des supports de dispositif OLED. Dans ce dernier cas, l'élément d'ossature peut notamment être un profilé en T, où la barre horizontale du profilé en T est en appui contre les faces avant de bords amincis des deux supports juxtaposés alors que la barre verticale du profilé en T passe entre les deux supports pour être reliée, à l'arrière des supports, à la structure porteuse supportant le panneau lumineux.

∘ Les moyens formant joint lumineux comprennent une bande électroluminescente disposée dans, ou à l'arrière de, la zone intermédiaire, l'état allumé ou éteint de la bande électroluminescente étant asservi à celui des deux dispositifs OLED.

∘ Les moyens formant joint lumineux comprennent des moyens de diffusion, vers l'avant de la zone intermédiaire, de la lumière émise par une source lumineuse.

∘ La source lumineuse comprend au moins l'un des deux dispositifs OLED, les moyens de diffusion comprenant un élément de redirection, vers l'avant de la zone intermédiaire, du rayonnement lumineux émis par le dispositif OLED.

∘ L'élément de redirection comporte au moins une surface réfléchissante de lumière qui est positionnée, à l'arrière de la zone intermédiaire, en regard d'un bord dudit dispositif OLED. Dans ce cas, la largeur maximale de la zone intermédiaire, prise perpendiculairement aux bords adjacents des deux zones émissives, est avantageusement inférieure ou égale à 2 mm, de préférence inférieure ou égale à 1 mm, encore de préférence inférieure ou égale à 0,5 mm.

∘ La surface réfléchissante est inclinée par rapport au bord dudit dispositif OLED de manière à s'éloigner du bord en direction de la zone intermédiaire.

∘ L'élément de redirection est un prisme disposé à l'arrière de la zone intermédiaire entre deux bords adjacents des deux dispositifs OLED juxtaposés, une première surface réfléchissante du prisme étant en regard du bord de l'un des deux dispositifs OLED alors qu'une deuxième surface réfléchissante du prisme est en regard du bord de l'autre dispositif OLED. En pratique, chaque surface réfléchissante du prisme peut être une surface munie d'un revêtement réfléchissant la lumière ou d'un revêtement redirecteur par diffusion de la lumière, par exemple un revêtement blanc d'albédo élevé, notamment supérieur ou égal à 80%. En variante, chaque surface réfléchissante du prisme peut réfléchir la lumière par réflexion totale, ce qui peut être obtenu en ajustant l'indice de réfraction du matériau constitutif du prisme et l'angle d'incidence de la lumière sur la surface.

∘ L'élément de redirection est une portion usinée d'un support d'au moins l'un des deux dispositifs OLED, cette portion usinée formant la surface réfléchissante. En particulier, le support peut être une plaque de parement de cloison ou de plafond, la portion usinée du support étant alors avantageusement munie, afin de former la surface réfléchissante, d'un revêtement réfléchissant la lumière ou d'un revêtement redirecteur par diffusion de la lumière, par exemple un revêtement blanc d'albédo élevé, notamment supérieur ou égal à 80%.

∘ La source lumineuse est une source externe couplée à la tranche d'une plaque diffusive, la plaque diffusive étant disposée dans, ou à l'arrière de, la zone intermédiaire, une face principale de la plaque diffusive dirigée vers l'avant de la zone intermédiaire étant apte à extraire au moins une partie du rayonnement émis par la source lumineuse externe.

∘ La plaque diffusive comporte sur l'une de ses faces principales un motif d'extraction de rayonnement émis par la source lumineuse externe, notamment un motif d'extraction sérigraphié, garantissant une luminance homogène sur toute la surface de la zone intermédiaire.

La présente invention a également pour objet une paroi de bâtiment, notamment une cloison ou un plafond, comprenant un panneau lumineux tel que décrit ci-dessus.

De manière avantageuse, une paroi de bâtiment selon l'invention comprend un panneau lumineux qui comporte :

- au moins un élément structurel de la paroi de bâtiment, notamment une plaque de parement de mur ou de plafond, et
- au moins deux dispositif OLED juxtaposés, qui forment une face avant du panneau lumineux et définissent deux zones émissives de lumière séparées par une zone intermédiaire de lumière,

où chaque dispositif OLED est assemblé avec un élément structurel de la paroi de bâtiment, notamment avec une plaque de parement de mur ou de plafond, le panneau lumineux comportant en outre des moyens formant joint lumineux qui assurent, à l'état allumé des deux dispositifs OLED, une continuité d'aspect entre la zone intermédiaire et les deux zones émissives, les moyens formant joint lumineux étant situés à l'arrière de, ou en affleurement avec, la face avant du panneau lumineux.

Les caractéristiques et avantages de l'invention apparaîtront dans la description qui va suivre de plusieurs modes de réalisation d'un panneau lumineux selon l'invention, donnée uniquement à titre d'exemple et faite en se référant aux dessins annexés dans lesquels :

- la figure 1 est une vue de face partielle d'une cloison murale de bâtiment comprenant un panneau lumineux conforme à l'invention ;
- la figure 2 est une coupe selon la ligne II-II de la figure 1 ;
- la figure 3 est une coupe à plus grande échelle selon la ligne III-III de la figure 1 pour un premier mode de réalisation du panneau lumineux ;

- la figure 4 est une vue analogue à la figure 3 pour une variante du premier mode de réalisation ;
- la figure 5 est une vue analogue à la figure 3 pour une autre variante du premier mode de réalisation ;
- la figure 6 est une vue analogue à la figure 3 pour un deuxième mode de réalisation du panneau lumineux ;
- la figure 7 est une vue à plus grande échelle du détail VII de la figure 1 pour un troisième mode de réalisation du panneau lumineux ;
- la figure 8 est une coupe à plus grande échelle selon la ligne VIII-VIII de la figure 7 ;
- les figures 9, 10, 11 sont des vues analogues, respectivement, aux figures 3, 4, 6, qui illustrent le cas où les moyens formant joint lumineux sont solidaires, non pas directement des supports des dispositifs OLED, mais d'éléments d'ossature qui assurent la fixation des supports de dispositifs OLED sur une structure porteuse supportant le panneau lumineux ;
- la figure 12 est une vue de face d'une variante du panneau lumineux de la figure 1 ; et
- la figure 13 est une coupe partielle selon la ligne XIII-XIII de la figure 12.

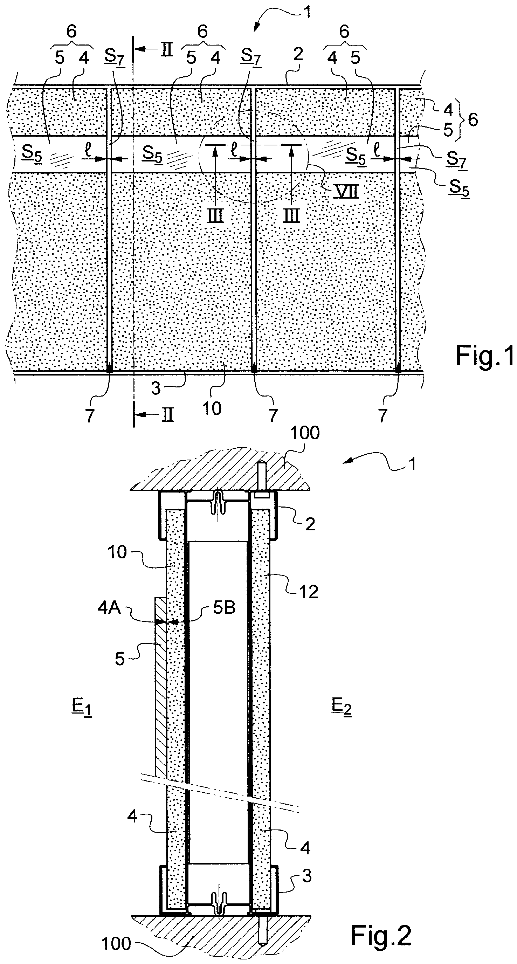

Les figures 1 à 13 sont schématiques. En particulier, dans un souci de visibilité, les dimensions relatives des différents éléments constitutifs de la cloison murale n'ont pas été strictement respectées sur ces figures.

Sur les figures 1 et 2 est représentée une cloison murale 1 de type cloison démontable. La cloison 1 comprend une lisse haute 2 et une lisse basse 3 qui sont reliées à une structure porteuse 100 supportant la cloison, des montants verticaux, non représentés, ainsi que des plaques de parement 4 qui sont par exemple des plaques de plâtre telles que celles connues sous l'appellation BA13. Comme bien visible sur la figure 2, les plaques de parement 4 sont positionnées dans l'ossature de la cloison de manière à former deux panneaux 10 et 12 qui s'étendent sensiblement parallèlement l'un à l'autre et qui jouent le rôle de parois pour, respectivement, un espace E1 et un espace E2 délimités par la cloison.

Comme montré sur la figure 1, les plaques de parement 4 du panneau 10 sont revêtues, dans une partie supérieure de leur face dirigée vers l'espace E1, de dispositifs OLED 5. Les dispositifs OLED 5 peuvent être de tout type, en particulier rigide ou flexible. L'alimentation électrique de ces dispositifs OLED 5 est assurée par tout moyen connu de l'homme du métier, et est contrôlable par l'intermédiaire d'un ou de plusieurs interrupteurs de manière à réguler la luminosité dans l'espace E1. Ainsi, grâce à son panneau lumineux 10, la cloison 1 joue pour l'espace E1 un double rôle de paroi et de luminaire.

Chaque dispositif OLED 5 est assemblé avec la plaque de parement 4 correspondante par tout moyen approprié, notamment par collage entre une face arrière 5B du dispositif OLED 5 et une face principale 4A de la plaque 4, l'ensemble formant une plaque lumineuse 6. Dans la configuration montée de la cloison 1, les dispositifs OLED 5 des différentes plaques lumineuses 6 du panneau 10 sont juxtaposés de manière à former une surface lumineuse continue de grande dimension. Dans cet exemple, tous les dispositifs OLED 5 du panneau 10 ont les mêmes propriétés optiques, notamment en termes de caractéristiques colorimétriques, de sorte que la surface lumineuse du panneau 10 est homogène d'un dispositif OLED 5 à un autre.

Chaque région 7 de jonction entre deux plaques lumineuses 6 adjacentes du panneau, qui correspond à l'emplacement habituel des systèmes de jointoiement entre deux plaques de parement, n'est pas émissive de lumière. Plus précisément, pour chaque région de jonction 7, les deux dispositifs OLED 5 positionnés de part et d'autre de cette région forment la face avant 10A du panneau lumineux 10 et définissent sur cette face avant 10A, qui est dirigée vers l'espace E1, deux zones émissives de lumière $S_5$ séparées par une zone intermédiaire $S_7$ non émissive de lumière. Chaque zone intermédiaire $S_7$ présente une largeur maximale $\ell$, prise perpendiculairement aux bords adjacents des zones émissives $S_5$, inférieure ou égale à 2 cm, de préférence inférieure ou égale à 1 cm, encore de préférence inférieure ou égale à 0,5 cm.

Afin de conférer au panneau 10 un aspect uniforme à l'état allumé de dispositifs OLED 5 adjacents, des moyens formant joint lumineux sont prévus au niveau de chaque zone intermédiaire $S_7$. Ces moyens formant joint lumineux sont choisis pour assurer, à l'état allumé de deux dispositifs OLED 5 adjacents, que l'écart relatif de luminance $\Delta L/L_m$ entre la zone intermédiaire $S_7$ et chacune des deux zones émissives $S_5$ qui l'encadrent est inférieure à 10%, de préférence inférieure à 5%, encore de préférence inférieure à 1%, et que les coordonnées (u', v') de la zone intermédiaire $S_7$ sont à l'intérieur de l'ellipse de Mac Adam centrée sur les coordonnées (u', v') de chacune des deux zones émissives $S_5$.

Afin de conférer au panneau 10 un aspect uniforme à l'état éteint de deux dispositifs OLED 5 adjacents, les moyens formant joint lumineux sont également choisis pour assurer que, à l'état éteint de deux dispositifs OLED 5 adjacents, l'écart relatif de luminance $\Delta L/L_m$ entre la zone intermédiaire $S_7$ et chacune des deux zones émissives $S_5$ est inférieure à 10%, de préférence inférieure à 5%, encore de préférence inférieure à 1%, et que la différence colorimétrique $\Delta E$ entre la zone intermédiaire $S_7$ et chacune des deux zones émissives $S_5$ est inférieure à 2, de préférence inférieure à 1. A l'état éteint des dispositifs OLED, l'écart relatif de luminance $\Delta L/L_m$ correspond à l'écart relatif de coefficient de réflexion entre la zone intermédiaire $S_7$ et chacune des deux zones émissives $S_5$.

En outre, afin de ne pas dégrader l'uniformité de surface de la face avant 10A du panneau 10, les moyens formant joint lumineux sont choisis pour être situés à l'arrière de, ou en affleurement avec, cette face avant 10A.

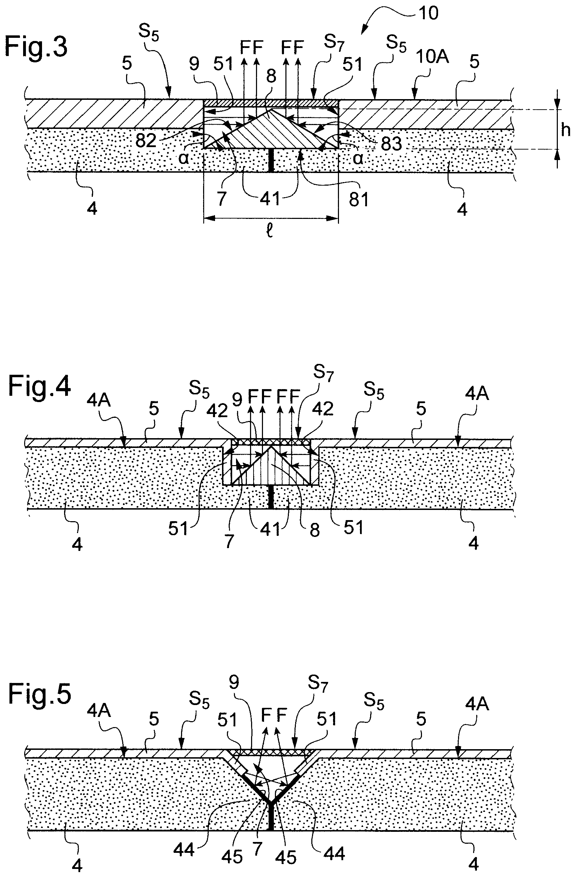

Des exemples de réalisation des moyens formant joint lumineux entre deux dispositifs OLED 5 du panneau lumineux 10 sont montrés sur les figures 3 à 6.

Dans le premier mode de réalisation représenté sur la figure 3, les moyens formant joint lumineux comprennent un prisme réflectif 8, disposé dans la zone de jonction 7, à l'arrière de la zone intermédiaire $S_7$. De manière avantageuse, chaque plaque de parement 4 du panneau 10 comporte des bords amincis 41 au niveau de la jonction avec les plaques de parement 4 adjacentes. Comme bien visible sur la figure 3, dans chaque région de jonction 7, les bords amincis 41 des deux plaques 4 adjacentes font saillie par rapport aux bords 51 des dispositifs OLED 5. Le prisme 8 est positionné entre les bords 51 des dispositifs OLED 5, avec sa base 81 qui repose sur les bords amincis 41, de telle sorte qu'une première surface réfléchissante 82 du prisme est en regard du bord 51 de l'un des dispositifs OLED 5, alors qu'une deuxième surface réfléchissante 83 du prisme est en regard du bord 51 de l'autre dispositif OLED 5.

Chaque surface réfléchissante 82 ou 83 du prisme 8 est inclinée selon un angle $\alpha$ de l'ordre de 45° par rapport au bord 51 du dispositif OLED en regard duquel elle est positionnée, de manière à s'éloigner du bord en direction de la zone intermédiaire $S_7$. Le prisme 8 peut être constitué en un matériau entièrement réfléchissant, ou en un matériau semi-réfléchissant ou transparent pourvu à sa surface d'un film redirecteur de rayonnement. La hauteur h du prisme 8 est adaptée de telle sorte que le prisme 8 s'insère entre les bords 51 en restant à l'arrière ou en affleurement par rapport à la face avant 10A du panneau lumineux.

Grâce à cet agencement, le prisme 8 permet de rediriger le rayonnement issu des bords 51 des dispositifs OLED 5 vers l'avant de la zone intermédiaire $S_7$, comme montré par les flèches F de la figure 3. Les dispositifs OLED ont une émission de rayonnement lambertienne, c'est-à-dire une émission de rayonnement dans toutes les directions de l'espace. Ainsi, le flux de rayonnement redirigé vers l'avant de la zone intermédiaire $S_7$ par le prisme 8 s'ajoute aux flux de rayonnement émis par les deux dispositifs OLED dans toutes les directions de l'espace, ce qui permet d'assurer une continuité d'aspect entre la zone intermédiaire $S_7$ et les deux zones émissives $S_5$ à l'état allumé des deux dispositifs OLED 5.

Dans ce premier mode de réalisation, les moyens formant joint lumineux comprennent également un film 9 en tant que revêtement de la zone intermédiaire $S_7$, qui est positionné à l'avant de la région de jonction 7 en étant affleurant par rapport à la face avant 10A du panneau lumineux 10. Ce film 9 est destiné à assurer une continuité d'aspect entre la zone intermédiaire $S_7$ et les deux zones émissives $S_5$ à l'état éteint des deux dispositifs OLED 5, et est choisi de manière à satisfaire aux critères précités d'écart relatif de luminance $\Delta L/L_m$ et de différence colorimétrique $\Delta E$ à l'état éteint des deux dispositifs OLED 5. À titre d'exemple, lorsque les faces avant des deux dispositifs OLED 5 sont semi-réfléchissantes à l'état éteint, le film 9 peut-être un film semi-réflectif. L'ensemble comprenant le prisme 8 et le film 9 est également optimisé de manière à satisfaire aux critères précités d'écart relatif de luminance $\Delta L/L_m$ et de différence colorimétrique déterminée à partir des ellipses de Mac Adam à l'état allumé des deux dispositifs OLED 5.

Les figures 4 et 5 montrent deux variantes du mode de réalisation de la figure 3, dans lesquelles les deux dispositifs OLED 5 juxtaposés sont des dispositifs OLED flexibles. Dans ces variantes, chaque dispositif OLED flexible 5 s'étend sur la face principale 4A de la plaque de parement 4 correspondante et est replié latéralement dans la zone de jonction 7, en direction des bords amincis 41 de la plaque 4, à chaque fois le long d'une face 42 de la plaque 4 reliant la face principale 4A et le bord aminci 41.

Dans la variante de la figure 4, le prisme 8 est positionné entre les bords 51 des dispositifs OLED 5 repliés le long des faces 42, avec sa base 81 qui repose sur les bords amincis 41, de telle sorte qu'une première surface réfléchissante 82 du prisme est en regard du bord replié 51 de l'un des dispositifs OLED 5, alors qu'une deuxième surface réfléchissante 83 du prisme est en regard du bord replié 51 de l'autre dispositif OLED 5. Cette configuration est plus compacte que celle de la figure 3.

Dans la variante de la figure 5, le prisme réflectif 8 est remplacé par des portions usinées 44 de chacune des deux plaques 4 de support des dispositifs OLED 5 flexibles, ces portions usinées 44 étant munies chacune, afin de former des surfaces réfléchissantes, d'un revêtement 45 réfléchissant la lumière ou redirecteur par diffusion de la lumière, par exemple un revêtement blanc d'albédo élevé, notamment supérieur ou égal à 80%. Les deux portions usinées 44 munies de leurs revêtements 45 permettent ainsi, de manière similaire au prisme 8, de rediriger le rayonnement issu des bords repliés 51 des dispositifs OLED 5 vers l'avant de la zone intermédiaire $S_7$, comme montré par les flèches F de la figure 5.

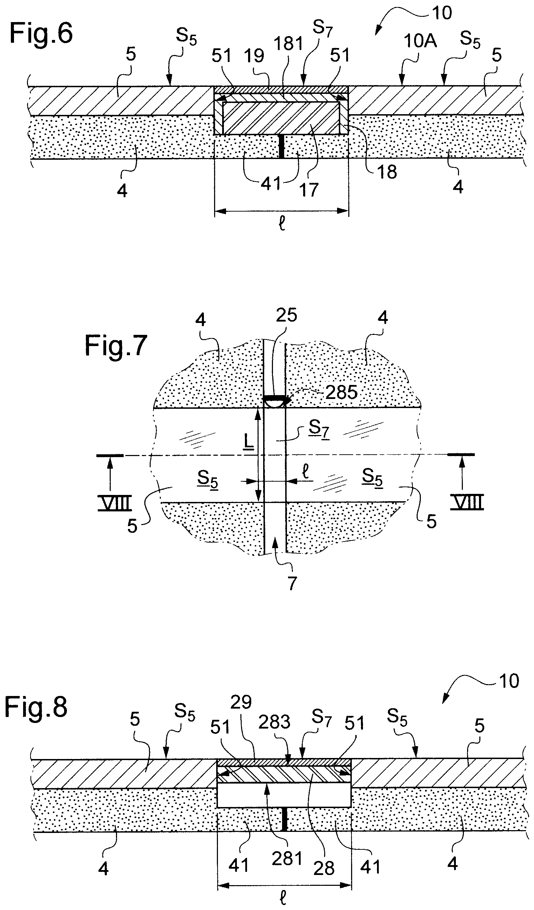

Dans le deuxième mode de réalisation représenté sur la figure 6, les moyens formant joint lumineux comprennent une bande électroluminescente 18, disposée à l'arrière de la zone intermédiaire $S_7$. Comme précédemment, chaque plaque de parement 4 comporte des bords amincis 41 en saillie par rapport aux bords 51 des dispositifs OLED 5, et la bande électroluminescente 18 est positionnée entre les bords 51 des dispositifs OLED 5. Plus précisément, la bande électroluminescente 18 est repliée en forme de U autour d'un bloc de remplissage 17 positionné en appui sur les bords amincis 41, la partie 181 de la bande 18 qui forme le fond du U étant dirigée vers la zone intermédiaire $S_7$. La bande électroluminescente 18 peut par exemple être une bande de dispositif OLED flexible ou une bande électroluminescente inorganique. Telle que représentée sur la figure 4, la partie 181 de la bande électroluminescente 18 a une largeur correspondant à la totalité de la largeur $\ell$ de la zone intermédiaire $S_7$. En variante, la bande électroluminescente 18 peut recouvrir une largeur correspondant à une fraction de la largeur $\ell$ de la zone intermédiaire $S_7$. De préférence, la bande électroluminescente 18 couvre entre 50% et 100% de la largeur $\ell$ de la zone intermédiaire $S_7$.

Lorsque la bande électroluminescente 18, dans son état éteint, satisfait aux critères précités d'écart relatif de luminance $\Delta L/L_m$ et de différence colorimétrique $\Delta E$ à l'état éteint des deux dispositifs OLED 5, elle est avantageusement prévue pour être affleurante par rapport à la face avant 10A du panneau lumineux 10. De plus, la bande électroluminescente 18 est choisie de manière à satisfaire, dans son état allumé, aux critères précités d'écart relatif de luminance $\Delta L/L_m$ et de différence colorimétrique déterminée à partir des ellipses de Mac Adam à l'état allumé des deux dispositifs OLED 5. La bande électroluminescente 18 permet ainsi d'assurer une continuité d'aspect entre la zone intermédiaire $S_7$ et les deux zones émissives $S_5$ à l'état allumé des deux dispositifs OLED 5 et de la bande électroluminescente 18. De manière avantageuse, l'état allumé ou éteint de la bande électroluminescente 18 est asservi à celui des deux dispositifs OLED, de telle sorte que la bande électroluminescente 18 est à l'état allumé uniquement lorsque les dispositifs OLED qui l'encadrent sont tous les deux à l'état allumé.

Lorsque la bande électroluminescente 18, dans son état éteint, ne satisfait pas aux critères précités en termes d'écart relatif de luminance $\Delta L/L_m$ et de différence colorimétrique $\Delta E$ à l'état éteint des deux dispositifs OLED 5, les moyens formant joint lumineux comprennent, en plus de la bande électroluminescente 18, un film 19 formant un revêtement de la zone intermédiaire $S_7$, qui est positionné à l'avant de la bande électroluminescente 18 en étant affleurant par rapport à la face avant 10A du panneau lumineux 10, comme montré sur la figure 4. L'empilement de la bande électroluminescente 18 et du film 19 est choisi de manière à satisfaire aux critères précités d'écart relatif de luminance $\Delta L/L_m$ et de différence colorimétrique $\Delta E$ à l'état éteint des deux dispositifs OLED 5 et de la bande électroluminescente 18, de manière à assurer une continuité d'aspect entre la zone intermédiaire $S_7$ et les deux zones émissives $S_5$ à l'état éteint. De plus, l'empilement de la bande électroluminescente 18 et du film 19 est choisi de manière à satisfaire aux critères précités d'écart relatif de luminance $\Delta L/L_m$ et de différence colorimétrique déterminée à partir des ellipses de Mac Adam à l'état allumé à la fois des deux dispositifs OLED 5 et de la bande électroluminescente 18, de manière à assurer une continuité d'aspect entre la zone intermédiaire $S_7$ et les deux zones émissives $S_5$ à l'état allumé.

Dans le troisième mode de réalisation représentée sur les figures 7 et 8, les moyens formant joint lumineux comprennent un système d'éclairage par la tranche, formé par l'association d'une plaque diffusive 28 et d'une source lumineuse externe 25 propre à injecter un rayonnement dans la plaque diffusive 28 à partir d'un chant 285 de celle-ci. Comme précédemment, chaque plaque de parement 4 comporte des bords amincis 41 en saillie par rapport aux bords 51 des dispositifs OLED 5. La plaque diffusive 28 est positionnée en contact entre les bords 51 des dispositifs OLED 5, avec sa face arrière 281 disposée en regard des bords amincis 41. La face avant 283 de la plaque diffusive 28 est apte à extraire au moins une partie du rayonnement émis par la source externe 25. À cet effet, la plaque diffusive 28 comporte sur sa face arrière 281 un motif d'extraction de rayonnement. À titre d'exemple, la source externe 25 est une diode électroluminescente (LED) et la plaque diffusive 28 est une plaque transparente en verre ou en matériau organique polymère comportant sur une de ses faces une série de points sérigraphiés formant un gradient d'extraction qui assure une extraction homogène de rayonnement le long de la région de jonction 7.

Comme précédemment, les moyens formant joint lumineux comprennent également un film 29 formant un revêtement de la zone intermédiaire $S_7$, qui est positionné à l'avant de la plaque diffusive 28 en étant affleurant par rapport à la face avant 10A du panneau lumineux 10. L'empilement de la plaque diffusive 28 et du film 29 est choisi de manière à satisfaire aux critères précités d'écart relatif de luminance $\Delta L/L_m$ et de différence colorimétrique $\Delta E$, à l'état éteint des deux dispositifs OLED 5 et de la source lumineuse externe 25, de manière à assurer une continuité d'aspect entre la zone intermédiaire $S_7$ et les deux zones émissives $S_5$ à l'état éteint. De plus, l'empilement de la plaque diffusive 28 et du film 29 est choisi de manière à satisfaire aux critères précités d'écart relatif de luminance $\Delta L/L_m$ et de différence colorimétrique déterminée à partir des ellipses de Mac Adam, à l'état allumé à la fois des deux dispositifs OLED 5 et de la source lumineuse externe 25, de manière à assurer une continuité d'aspect entre la zone intermédiaire $S_7$ et les deux zones émissives $S_5$ à l'état allumé. De manière avantageuse, l'état allumé ou éteint de la source externe 25 est asservi à celui des deux dispositifs OLED, de telle sorte que la source externe 25 est à l'état allumé uniquement lorsque les dispositifs OLED qui encadrent la plaque diffusive 28 sont tous les deux à l'état allumé.

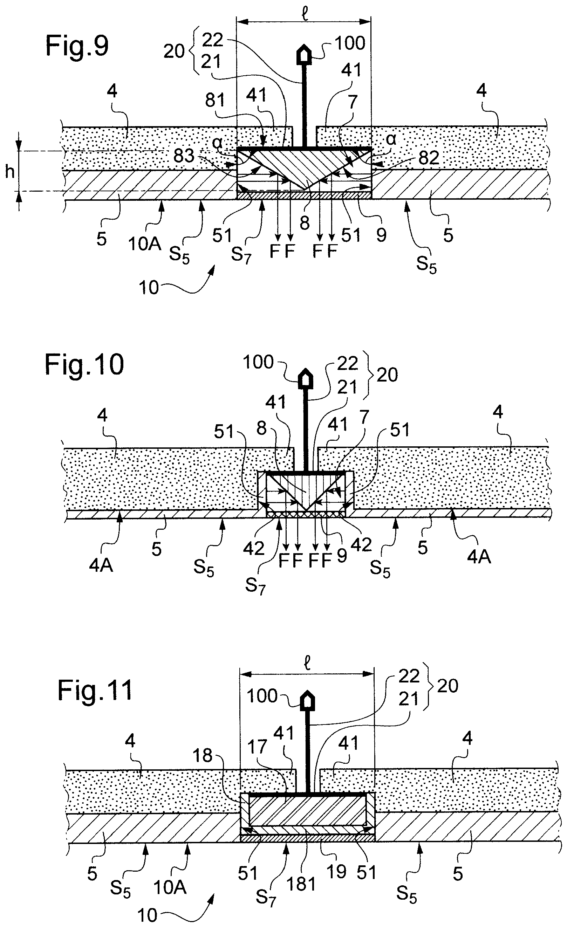

Les figures 9, 10 et 11 illustrent des variantes des modes de réalisation des figures 3, 4 et 6, respectivement, dans lesquelles les moyens formant joint lumineux sont solidaires, non pas directement des plaques de parement 4 supportant les dispositifs OLED 5, mais d'éléments d'ossature qui assurent la fixation des plaques de parement 4 sur la structure porteuse 100 supportant le panneau lumineux. Plus précisément, sur chacune des figures 9, 10 et 11, les deux plaques de parement 4 juxtaposées sont reliées à la structure porteuse 100 par un profilé 20 à section en T qui joue le rôle d'élément d'ossature. Un tel agencement avec profilés en T est classiquement utilisé pour la fixation de dalles de plafond à une structure porteuse. Comme bien visible sur les figures 9 à 11, la barre horizontale 21 du profilé 20 en T est en appui contre les faces avant des bords amincis 41 des deux plaques de parement 4 juxtaposées, tandis que la barre verticale 22 du profilé 20 en T passe entre les deux plaques de parement 4 pour être reliée, à l'arrière des plaques de parement 4, à la structure porteuse 100.

Les moyens formant joint lumineux sont alors positionnés à l'avant de la barre horizontale 21 du profilé 20 en T et peuvent être solidaires de celle-ci. En particulier, sur les figures 9 et 10, le prisme 8 est positionné avec sa base 81 qui repose sur la barre horizontale 21 du profilé 20 en T, de telle sorte qu'une première surface réfléchissante 82 du prisme est en regard du bord 51 de l'un des dispositifs OLED 5, alors qu'une deuxième surface réfléchissante 83 du prisme est en regard du bord 51 de l'autre dispositif OLED 5. Sur la figure 11, la bande électroluminescente 18 est repliée en forme de U autour d'un bloc de remplissage 17 positionné en appui sur la barre horizontale 21 du profilé 20 en T.

Bien entendu, des profilés en T peuvent également être utilisés avec les moyens formant joint lumineux représentés sur la figure 8, qui comprennent un système d'éclairage par la tranche, la plaque diffusive 28 étant alors positionnée en contact entre les bords 51 des dispositifs OLED 5, avec sa face arrière disposée en regard de la barre horizontale 21 du profilé en T.

Comme il ressort des modes de réalisation décrit ci-dessus, un panneau lumineux conforme à l'invention permet d'obtenir une surface lumineuse de grande dimension, dont l'aspect est uniforme à la fois à l'état allumé et à l'état éteint, même à la jonction entre deux dispositifs OLED distincts juxtaposés. De manière très avantageuse, un panneau lumineux conforme à l'invention est facilement intégrable dans un système d'ossature classique de paroi de bâtiment, en particulier de cloison ou de plafond, ce qui permet de former de façon particulièrement aisée une paroi de bâtiment assurant une fonction de luminaire.

L'invention n'est pas limitée aux modes de réalisation décrits et représentés. En particulier, le ou chaque support de dispositif OLED d'un panneau lumineux conforme à l'invention peut être différent d'une plaque de parement en plâtre. Tout support apte à être intégré dans la réalisation d'une paroi de bâtiment est utilisable dans le cadre de l'invention, ce qui comprend, à titre d'exemples non limitatifs, des dalles en laine de verre, des panneaux mélaminés, des panneaux stratifiés, des plaques en bois naturel, des plaques métalliques. En particulier, lorsque le panneau lumineux comprend une pluralité de supports de dispositifs OLED juxtaposés les uns par rapport aux autres, ces supports peuvent être tous de même nature ou être de natures différentes. Ainsi, dans le mode de réalisation de la figure 1, le panneau lumineux 10 peut comprendre, au lieu d'une pluralité de plaques de parement en plâtre juxtaposées, des plaques de natures différentes juxtaposées, par exemple des plaques de plâtre juxtaposées avec des plaques en bois.

Le revêtement de chaque zone intermédiaire du panneau lumineux, qui assure la continuité d'aspect du panneau à l'état éteint des dispositifs OLED, peut également être de tout type, notamment un film rapporté à l'avant des éléments lumineux comme dans les exemples précédents, ou encore une couche mince déposée sur les éléments lumineux. On entend ici par "éléments lumineux" les éléments formant joint lumineux qui émettent de la lumière en tant que sources primaires ou secondaires, à savoir le prisme 8, la bande électroluminescente 18 et la plaque diffusive 28 dans les exemples précédents.

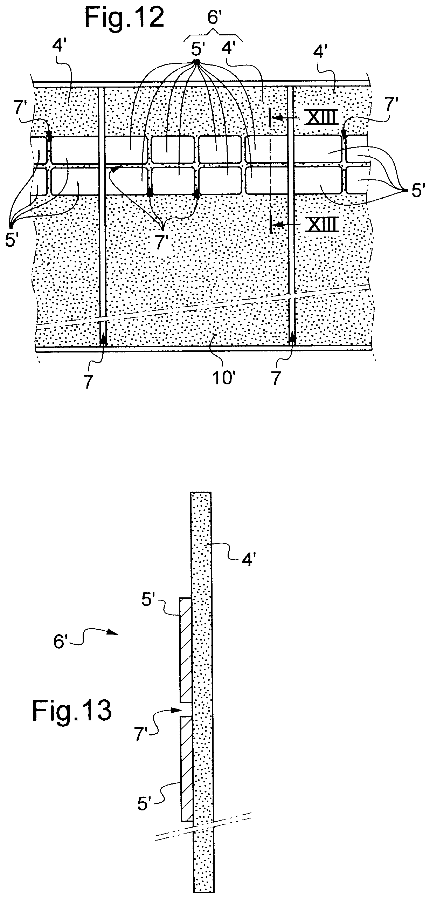

Par ailleurs, dans les modes de réalisation précédents, chaque plaque lumineuse 6 est obtenue en recouvrant le support avec un dispositif OLED unique, les régions de jonction 7 entre deux dispositifs OLED 5 correspondant à chaque fois à la jonction entre deux plaques lumineuses 6 juxtaposées. En variante, et en particulier lorsque les dimensions souhaitées de la surface lumineuse sur la plaque lumineuse excèdent les dimensions disponibles de dispositifs OLED, une plaque lumineuse peut être obtenue en recouvrant un support avec une pluralité de dispositifs OLED juxtaposés. Ce cas est illustré sur les figures 12 et 13 montrant un panneau lumineux 10' obtenu par l'assemblage de plaques lumineuses 6', où chaque plaque lumineuse 6' comprend une plaque de parement 4' revêtue, dans une partie supérieure de l'une de ses faces principales, d'une pluralité de dispositifs OLED 5' rigides ou flexibles formant un quadrillage. Le panneau lumineux 10' obtenu par juxtaposition de ces plaques lumineuses 6' présente des discontinuités d'aspect non seulement à chaque région 7 de jonction entre deux plaques lumineuses 6' juxtaposées, mais également à chaque région 7' de jonction entre deux dispositifs OLED 5' juxtaposés sur chacune des plaques 4'. Des moyens formant joint lumineux tels que décrits précédemment, en référence aux figures 3 à 8, pour assurer une continuité d'aspect dans les régions de jonction 7 peuvent également être utilisés pour assurer une continuité d'aspect dans les régions de jonction 7'.

Enfin, l'invention a été illustrée sur les figures 1 et 2 dans le cas d'une ossature de cloison de type démontable. L'invention est toutefois également applicable avec d'autres types d'ossatures. En particulier, un panneau lumineux selon l'invention peut aussi être mis en oeuvre pour réaliser un plafond, le panneau étant alors généralement relié à une structure réalisée sous un plancher. Les plaques de parement, qui dans ce cas sont appelées dalles de plafond, peuvent notamment être reliées à la structure par l'intermédiaire de profilés en T, comme montré sur les figures 9 à 11.

EXEMPLES

Exemple n°1 (exemple comparatif)

Les deux dispositifs OLED 5 sont deux composants rectangulaires "Lumiblade Tall White" de la société Philips, agencés sur deux supports en plâtre juxtaposés. A l'état éteint, l'aspect de chaque dispositif OLED 5 est miroir. La zone intermédiaire $S_7$ entre les deux dispositifs OLED 5 a une largeur $\ell$ de 12 mm et une longueur $\underline{L}$ de 48 mm. Dans les conditions expérimentales d'alimentation des composants, la luminance moyenne de chaque dispositif OLED 5 est $L_m$

= 750 cd/m$^2$.

Aucun joint lumineux n'est rapporté dans la région 7 de jonction entre les deux dispositifs OLED 5.

Dans cet exemple, la zone intermédiaire S$_7$ crée une zone de discontinuité de couleur noire très nettement perçue entre les deux zones émissives S$_5$, à la fois à l'état éteint et à l'état allumé des deux dispositifs OLED 5.

Exemple n°2

Les deux dispositifs OLED 5 sont deux composants rectangulaires "Lumiblade Tall White" de la société Philips, agencés sur deux supports en plâtre juxtaposés. A l'état éteint, l'aspect de chaque dispositif OLED 5 est miroir. Pour les besoins esthétiques de l'application, les dispositifs OLED 5 et la région de jonction 7 sont recouverts d'un film translucide standard, choisi dans la gamme "Scotchtal" de la société 3M. La zone intermédiaire S$_7$ entre les deux dispositifs OLED 5 a une largeur ℓ de 7 mm et une longueur L de 48 mm. Dans les conditions expérimentales d'alimentation des composants, la luminance moyenne de chaque dispositif OLED 5 est $L_m$ = 750 cd/m$^2$.

Un prisme 8 en matériau transparent, pourvu à sa surface d'un film redirecteur de rayonnement de type "OLF" (Optical Lighting Film) de la société 3M, est positionné dans la région 7 de jonction entre les deux dispositifs OLED 5, comme montré sur la figure 3. Le prisme 8 a une hauteur h de 4 mm.

Exemple n°3

Les deux dispositifs OLED 5 sont deux composants rectangulaires "Lumiblade Tall White" de la société Philips, agencés sur deux supports en plâtre juxtaposés. A l'état éteint, l'aspect de chaque dispositif OLED 5 est miroir. La zone intermédiaire S$_7$ entre les deux dispositifs OLED 5 a une largeur ℓ de 12 mm et une longueur L de 48 mm. Dans les conditions expérimentales d'alimentation des composants, la luminance moyenne de chaque dispositif OLED 5 est $L_m$ = 750 cd/m$^2$.

Un système d'éclairage par la tranche est placé à l'arrière de la zone intermédiaire S$_7$, comme montré sur la figure 8, ce système comprenant :

- une plaque diffusive 28 en verre clair transparent "Planilux" de la société Saint-Gobain Glass, d'épaisseur 2 mm, sérigraphié sur sa face arrière 281 avec un motif formant un gradient d'extraction,
- une LED 25 "Luxeon Rebel" de la société Philips de température de couleur 2700K Rebel, couplée à chant 285 de la plaque diffusive 28.

Un film formé par une couche semi-réflective 29 en mylar est positionné à l'avant de la région de jonction 7 en étant affleurant par rapport aux faces avant des deux dispositifs OLED 5, comme montré sur la figure 8.

Les propriétés d'alimentation de la LED 28 sont choisies de façon corrélée avec les propriétés d'absorption et de transmission de la plaque de diffusion de manière à assurer la continuité d'aspect au sens de la luminance. En particulier, dans cet exemple, la LED 25 est alimentée avec un courant de 350 mA et une tension 2,8 V.

Les caractéristiques optiques des panneaux lumineux des exemples n°1 à 3 sont données dans le tableau 1 ci-dessous.

**Tableau 1**

| | Etat éteint | | Etat allumé | |
|---|---|---|---|---|
| | $\Delta L/L_m$ (%) | $\Delta E$ (%) | $\Delta L/L_m$ (%) | Critère des ellipses de Mac Adam |
| Exemple n°1 | La zone intermédiaire est une zone de discontinuité de couleur noire | | | |
| Exemple n°2 | < 2 | < 1 | 6 | Conforme au critère : les coordonnées (u', v') de la zone intermédiaire sont à l'intérieur de l'ellipse de Mac Adam 14 centrée sur les coordonnées (u'=0,257, v'=0,527) de chacune des deux zones émissives |
| Exemple n°3 | 8 | 2 | 5 | Conforme au critère : les coordonnées (u', v') de la zone intermédiaire sont à l'intérieur de l'ellipse de Mac Adam 14 centrée sur les coordonnées (u'=0,257, v'=0,527) de chacune des deux zones émissives |

Les grandeurs du tableau 1 ont été mesurées de la façon suivante :

Etat allumé : les mesures sont réalisées à l'aide du vidéo-photocolorimètre LC Lumicam 1300-202. Les dispositifs OLED 5 sont placés à une distance de 0,5 m de l'appareil photo. L'objectif utilisé est un objectif 28 mm, l'ouverture du diaphragme est 2,8. Les valeurs de luminance mesurées correspondent aux valeurs dans l'axe perpendiculaire au plan des composants.

Etat éteint : les mesures de $L$, a* et b* sont réalisées en incidence normale en utilisant le spectromètre Minolta CM-2700d.

## Revendications

1. Panneau lumineux (10) comprenant au moins deux dispositifs OLED (5, 5') juxtaposés qui forment une face avant (10A) du panneau lumineux et définissent deux zones émissives de lumière ($S_5$) séparées par une zone intermédiaire de lumière ($S_7$), **caractérisé en ce que** chaque dispositif OLED (5, 5') est assemblé avec un élément structurel d'une paroi de bâtiment, notamment une plaque de parement (4, 4') de mur ou de plafond, le panneau lumineux comprenant des moyens (8, 9; 18, 19; 25, 28, 29) formant joint lumineux qui assurent, à l'état allumé des deux dispositifs OLED (5, 5'), une continuité d'aspect entre la zone intermédiaire ($S_7$) et les deux zones émissives ($S_5$), les moyens formant joint lumineux étant situés à l'arrière de, ou en affleurement avec, ladite face avant (10A) du panneau lumineux (10).

2. Panneau lumineux selon la revendication 1, **caractérisé en ce que**, à l'état allumé des deux dispositifs OLED (5, 5'), l'écart relatif de luminance ($\Delta L/L_m$), pris dans le système de coordonnées colorimétriques CIE (L, u', v'), entre la zone intermédiaire ($S_7$) et chacune des deux zones émissives ($S_5$) est inférieur à 10%, de préférence inférieur à 5%, encore de préférence inférieur à 1%.

3. Panneau lumineux selon l'une quelconque des revendications précédentes, **caractérisé en ce que**, à l'état allumé des deux dispositifs OLED (5, 5'), les coordonnées colorimétriques (u', v') de la zone intermédiaire ($S_7$) sont à l'intérieur de l'ellipse de Mac Adam centrée sur les coordonnées colorimétriques (u', v') de chacune des deux zones émissives ($S_5$).

4. Panneau lumineux selon l'une quelconque des revendications précédentes, **caractérisé en ce que** la zone intermédiaire ($S_7$) a une largeur maximale ($\ell$), prise perpendiculairement aux bords (51) adjacents des zones émissives ($S_5$), inférieure ou égale à 2 cm, de préférence inférieure ou égale à 1 cm, encore de préférence inférieure ou égale à 0,5 cm.

5. Panneau lumineux selon l'une quelconque des revendications précédentes, **caractérisé en ce qu'**il comprend un revêtement (9 ; 19 ; 29) de la zone intermédiaire ($S_7$), de telle sorte qu'il existe une continuité d'aspect entre la zone intermédiaire ($S_7$) et les deux zones émissives ($S_5$) à l'état éteint des deux dispositifs OLED (5, 5').

6. Panneau lumineux selon l'une quelconque des revendications précédentes, **caractérisé en ce que**, à l'état éteint des deux dispositifs OLED (5, 5'), l'écart relatif de luminance ($\Delta L/L_m$), pris dans le système de coordonnées colorimétriques CIE ($L, a*, b*$), entre la zone intermédiaire ($S_7$) et chacune des deux zones émissives ($S_5$) est inférieur à 10%, de préférence inférieur à 5%, encore de préférence inférieur à 1%.

7. Panneau lumineux selon l'une quelconque des revendications précédentes, **caractérisé en ce que**, à l'état éteint des deux dispositifs OLED (5, 5'), la différence colorimétrique ($\Delta E$), prise dans le système de coordonnées colorimétriques CIE ($L, a*, b*$), entre la zone intermédiaire ($S_7$) et chacune des deux zones émissives ($S_5$) est inférieure à 2, de préférence inférieure à 1.

8. Panneau lumineux selon l'une quelconque des revendications précédentes, **caractérisé en ce qu'**il comprend un support (4'), notamment une plaque de parement de cloison ou de plafond, les deux dispositifs OLED (5') étant juxtaposés sur une face (4A) du support.

9. Panneau lumineux selon l'une quelconque des revendications précédentes, **caractérisé en ce qu'**il comprend deux supports (4) juxtaposés, notamment deux plaques de parement de cloison ou de plafond, chaque support étant revêtu de l'un des deux dispositifs OLED (5).

10. Panneau lumineux selon la revendication 9, **caractérisé en ce que** les moyens formant joint lumineux sont solidaires d'un élément d'ossature (20) assurant la fixation d'un ou de chaque support (4) de dispositif OLED sur une structure porteuse (100).

**11.** Panneau lumineux selon l'une quelconque des revendications précédentes, **caractérisé en ce que** les moyens formant joint lumineux comprennent une bande électroluminescente (18) disposée dans, ou à l'arrière de, la zone intermédiaire ($S_7$).

**12.** Panneau lumineux selon l'une quelconque des revendications 1 à 10, **caractérisé en ce que** les moyens formant joint lumineux comprennent des moyens (8 ; 28) de diffusion, vers l'avant de la zone intermédiaire ($S_7$), de la lumière émise par une source lumineuse (5 ; 25).

**13.** Panneau lumineux selon la revendication 12, **caractérisé en ce que** la source lumineuse comprend au moins l'un des deux dispositifs OLED (5), les moyens de diffusion comprenant un élément de redirection (8 ; 44), vers l'avant de la zone intermédiaire ($S_7$), du rayonnement lumineux émis par ledit dispositif OLED (5).

**14.** Panneau lumineux selon la revendication 13, **caractérisé en ce que** l'élément de redirection (8 ; 44) comporte au moins une surface réfléchissante (82, 83) positionnée, à l'arrière de la zone intermédiaire ($S_7$), en regard d'un bord (51) dudit dispositif OLED (5).

**15.** Panneau lumineux selon la revendication 14, **caractérisé en ce que** l'élément de redirection (8) est un prisme disposé à l'arrière de la zone intermédiaire ($S_7$) entre deux bords (51) adjacents des deux dispositifs OLED (5) juxtaposés, une première surface réfléchissante (82) du prisme étant en regard du bord (51) de l'un des deux dispositifs OLED alors qu'une deuxième surface réfléchissante (83) du prisme est en regard du bord (51) de l'autre dispositif OLED.

**16.** Panneau lumineux selon la revendication 14, **caractérisé en ce que** l'élément de redirection est une portion usinée (44) d'un support (4) d'au moins l'un des deux dispositifs OLED (5), cette portion usinée (44) formant la surface réfléchissante.

**17.** Panneau lumineux selon la revendication 12, **caractérisé en ce que** la source lumineuse est une source externe (25) couplée à la tranche d'une plaque diffusive (28), la plaque diffusive (28) étant disposée dans, ou à l'arrière de, la zone intermédiaire ($S_7$), une face principale (283) de la plaque diffusive dirigée vers l'avant de la zone intermédiaire étant apte à extraire au moins une partie du rayonnement émis par la source lumineuse externe (25).

**18.** Panneau lumineux selon la revendication 17, **caractérisé en ce que** la plaque diffusive (28) comporte sur l'une (281) de ses faces principales un motif d'extraction de rayonnement émis par la source lumineuse externe (25), notamment un motif d'extraction sérigraphié.

**19.** Paroi de bâtiment, notamment cloison ou plafond, **caractérisée en ce qu'**elle comprend un panneau lumineux selon l'une quelconque des revendications précédentes.


**Patentansprüche**

**1.** Lichttafel (10), umfassend mindestens zwei nebeneinandergestellte OLED-Vorrichtungen (5, 5'), die eine vordere Seite (10A) der Lichttafel bilden und zwei Lichtemissionsbereiche ($S_5$) definieren, die durch einen Zwischenlichtbereich ($S_7$) getrennt sind, **dadurch gekennzeichnet, dass** jede OLED-Vorrichtung (5, 5') mit einem Strukturelement einer Gebäudewand, insbesondere einer Verkleidungsplatte (4, 4') einer Mauer oder einer Decke, montiert ist, wobei die Lichttafel Mittel (8, 9; 18, 19; 25, 28, 29) umfasst, die eine Lichtdichtung bilden, die im beleuchteten Zustand der zwei OLED-Vorrichtungen (5, 5') ein durchgängiges Erscheinungsbild zwischen dem Zwischenbereich ($S_7$) und den zwei Emissionsbereichen ($S_5$) sicherstellen, wobei die Mittel, die eine Lichtdichtung bilden, hinter der oder bündig mit der vorderen Seite (10A) der Lichttafel (10) angeordnet sind.

**2.** Lichttafel nach Anspruch 1, **dadurch gekennzeichnet, dass** im beleuchteten Zustand der zwei OLED-Vorrichtungen (5, 5') der relative Lichtdichteabstand ($\Delta L / L_m$), im kolorimetrischen Koordinatensystem CIE (L, u', v') gemessen, zwischen dem Zwischenbereich ($S_7$) und jedem der zwei Emissionsbereiche ($S_5$) kleiner als 10 % ist, vorzugsweise kleiner als 5 %, bevorzugter kleiner als 1 %.

3. Lichttafel nach einem der vorhergehenden Ansprüche, **dadurch gekennzeichnet, dass** im beleuchteten Zustand der zwei OLED-Vorrichtungen (5, 5') sich die kolorimetrischen Koordinaten (u', v') des Zwischenbereichs ($S_7$) im Inneren der Mac-Adam-Ellipse befinden und auf die kolorimetrischen Koordinaten (u', v') jedes der zwei Emissionsbereiche ($S_5$) zentriert sind.

4. Lichttafel nach einem der vorhergehenden Ansprüche, **dadurch gekennzeichnet, dass** der Zwischenbereich ($S_7$) eine maximale Breite (f), senkrecht zu den benachbarten Rändern (51) der Emissionsbereiche ($S_5$) gemessen, von kleiner als oder gleich 2 cm aufweist, vorzugsweise kleiner als oder gleich 1 cm, bevorzugter kleiner als oder gleich 0,5 cm.

5. Lichttafel nach einem der vorhergehenden Ansprüche, **dadurch gekennzeichnet, dass** sie eine Verkleidung (9; 19; 29) des Zwischenbereichs ($S_7$) umfasst, so dass im ausgeschalteten Zustand der zwei OLED-Vorrichtungen ein durchgängiges Erscheinungsbild zwischen dem Zwischenbereich ($S_7$) und den zwei Emissionsbereichen ($S_5$) (5, 5') existiert.

6. Lichttafel nach einem der vorhergehenden Ansprüche, **dadurch gekennzeichnet, dass** im ausgeschalteten Zustand der zwei OLED-Vorrichtungen (5, 5') der relative Lichtdichteabstand ($\Delta L / L_m$), im kolorimetrischen Koordinatensystem CIE (L, $a^*$, $b^*$) gemessen, zwischen dem Zwischenbereich ($S_7$) und jedem der zwei Emissionsbereiche ($S_5$) kleiner als 10 % ist, vorzugsweise kleiner als 5 %, bevorzugter kleiner als 1 %.

7. Lichttafel nach einem der vorhergehenden Ansprüche, **dadurch gekennzeichnet, dass** im ausgeschalteten Zustand der zwei OLED-Vorrichtungen (5, 5') die kolorimetrische Differenz ($\Delta E$), im kolorimetrischen Koordinatensystem CIE (L, a*, $b^*$) gemessen, zwischen dem Zwischenbereich ($S_7$) und jedem der zwei Emissionsbereiche ($S_5$) kleiner als 2 ist, vorzugsweise kleiner als 1.

8. Lichttafel nach einem der vorhergehenden Ansprüche, **dadurch gekennzeichnet, dass** sie einen Träger (4') umfasst, insbesondere einer Verkleidungsplatte einer Zwischenwand oder einer Decke, wobei die zwei OLED-Vorrichtungen (5') auf einer Seite (4A) des Trägers nebeneinandergestellt sind.

9. Lichttafel nach einem der vorhergehenden Ansprüche, **dadurch gekennzeichnet, dass** sie zwei nebeneinander gestellte Träger (4) umfasst, insbesondere zwei Verkleidungstafeln einer Zwischenwand oder einer Decke, wobei jeder Träger mit einer der zwei OLED-Vorrichtungen (5) verkleidet ist.

10. Lichttafel nach Anspruch 9, **dadurch gekennzeichnet, dass** die Mittel, die eine Lichtdichtung bilden, mit einem Gerüstelement (20) fest verbunden sind, das die Fixierung eines oder jedes Trägers (4) der OLED-Vorrichtung auf einer Tragestruktur (100) sicherstellt.

11. Lichttafel nach einem der vorhergehenden Ansprüche, **dadurch gekennzeichnet, dass** die Mittel, die eine Lichtdichtung bilden, ein elektrolumineszentes Band (18) umfassen, das sich im oder hinter dem Zwischenbereich ($S_7$) befindet.

12. Lichttafel nach einem beliebigen der Ansprüche 1 bis 10, **dadurch gekennzeichnet, dass** die Mittel, die eine Lichtdichtung bilden, Mittel (8; 28) zur Diffusion hin zur vorderen Seite des Zwischenbereichs ($S_7$), des durch eine Lichtquelle (5; 25) emittierten Lichts umfassen.

13. Lichttafel nach Anspruch 12, **dadurch gekennzeichnet, dass** die Lichtquelle mindestens eine der zwei OLED-Vorrichtungen (5) umfasst, wobei die Mittel zur Diffusion ein Element zur Umleitung (8; 44), hin zur vorderen Seite des Zwischenbereichs ($S_7$) der durch die OLED-Vorrichtung (5) emittierten Lichtstrahlung umfasst.

14. Lichttafel nach Anspruch 13, **dadurch gekennzeichnet, dass** das Element zur Umleitung (8; 44) mindestens eine reflektierende Oberfläche (82, 83) umfasst, die hinter dem Zwischenbereich ($S_7$) gegenüber einem Rand (51) der OLED-Vorrichtung (5) positioniert ist.

15. Lichttafel nach Anspruch 14, **dadurch gekennzeichnet, dass** das Element zur Umleitung (8) ein Prisma ist, das sich auf der hinteren Seite des Zwischenbereichs ($S_7$) zwischen zwei benachbarten Rändern (51) der zwei nebeneinandergestellten OLED-Vorrichtungen (5) befindet, wobei sich eine erste reflektierende Oberfläche (82) des Prismas gegenüber dem Rand (51) einer der zwei OLED-Vorrichtungen befindet, während sich eine zweite reflektierende Oberfläche (83) des Prismas gegenüber dem Rand (51) der anderen OLED-Vorrichtung befindet.

**16.** Lichttafel nach Anspruch 14, **dadurch gekennzeichnet, dass** das Element zur Umleitung ein bearbeiteter Abschnitt (44) eines Trägers (4) mindestens einer der zwei OLED-Vorrichtungen (5) ist, wobei dieser bearbeitete Abschnitt (44) die reflektierende Oberfläche bildet.

**17.** Lichttafel nach Anspruch 12, **dadurch gekennzeichnet, dass** die Lichtquelle eine externe Quelle (25) ist, die mit einer Scheibe der Diffusionsplatte (28) gekoppelt ist, wobei sich die Diffusionsplatte (28) in oder hinter dem Zwischenbereich ($S_7$) befindet, wobei eine Hauptseite (283) der Diffusionsplatte, die hin zur vorderen Seite des Zwischenbereichs gerichtet ist, ausgelegt ist, um mindestens einen Teil der Strahlung zu extrahieren, die von der externen Lichtquelle (25) emittiert wird.

**18.** Lichttafel nach Anspruch 17, **dadurch gekennzeichnet, dass** die Diffusionsplatte (28) an einer (281) ihrer Hauptseiten ein Muster, insbesondere ein serigraphiertes Muster zur Extraktion von Lichtstrahlung umfasst, die von der externen Lichtquelle (25) emittiert wurde.

**19.** Gebäudewand, insbesondere eine Trennwand oder eine Decke, **dadurch gekennzeichnet, dass** sie eine Lichttafel nach einem der vorhergehenden Ansprüche umfasst.


**Claims**

**1.** A luminous panel (10) comprising at least two juxtaposed OLED devices (5, 5') that form a front face (10A) of the luminous panel and define two light-emitting zones ($S_5$) separated by an intermediate zone ($S_7$), **characterized in that** each OLED device (5, 5') is joined to a structural element of a building wall, especially a cladding panel of a wall or a ceiling (4, 4'), the luminous panel comprising luminous joint forming means (8, 9; 18, 19; 25, 28, 29) that ensure, when the two OLED devices (5, 5') are in the "on" state, visual continuity between the intermediate zone ($S_7$) and the two emitting zones ($S_5$), the luminous joint forming means being located at the back of or flush with said front face (10A) of the luminous panel (10).

**2.** The luminous panel as claimed in either one of claims 1, **characterized in that**, when the two OLED devices (5, 5') are in the "on" state, the relative difference in luminance ($\Delta L/L_m$), expressed in the CIE (L, u', v') color coordinate system, between the intermediate zone ($S_7$) and each of the two emitting zones ($S_5$) is smaller than 10%, preferably smaller than 5%, even more preferably smaller than 1%.

**3.** The luminous panel as claimed in any one of the preceding claims, **characterized in that**, when the two OLED devices (5, 5') are in the "on" state, the (u', v') color coordinates of the intermediate zone ($S_7$) are inside the MacAdam ellipse centered on the (u', v') color coordinates of each of the two emitting zones ($S_5$).

**4.** The luminous panel as claimed in any one of the preceding claims, **characterized in that** the intermediate zone ($S_7$) has a maximum width ($\lambda$), measured perpendicularly to the adjacent edges (51) of the emitting zones ($S_5$), smaller than or equal to 2 cm, preferably smaller than or equal to 1 cm, even more preferably smaller than or equal to 0.5 cm.

**5.** The luminous panel as claimed in any one of the preceding claims, **characterized in that** it comprises a covering (9; 19; 29) of the intermediate zone ($S_7$), such that there is visual continuity between the intermediate zone ($S_7$) and the two emitting zones ($S_5$) when the two OLED devices (5, 5') are in the "off' state.

**6.** The luminous panel as claimed in any one of the preceding claims, **characterized in that**, when the two OLED devices (5, 5') are in the "off state, the relative difference in luminance ($\Delta L/L_m$), expressed in the CIE (L, a*, b*) color coordinate system, between the intermediate zone ($S_7$) and each of the two emitting zones ($S_5$) is smaller than 10%, preferably smaller than 5%, even more preferably smaller than 1%.

**7.** The luminous panel as claimed in any one of the preceding claims, **characterized in that**, when the two OLED devices (5, 5') are in the "off" state, the color difference ($\Delta E$), expressed in the CIE (L, a*, b*) color coordinate system, between the intermediate zone ($S_7$) and each of the two emitting zones ($S_5$) is smaller than 2, preferably smaller than 1.

**8.** The luminous panel as claimed in any one of the preceding claims, **characterized in that** it comprises a support (4'), especially a cladding panel of an internal wall or a ceiling, the two OLED devices (5') being juxtaposed on one face (4A) of the support.

9. The luminous panel as claimed in any one of the preceding claims, **characterized in that** it comprises two juxtaposed supports (4), especially two cladding panels of an internal wall or a ceiling, each support being covered with one of the two OLED devices (5).

10. The luminous panel as claimed in claim 9, **characterized in that** the luminous joint forming means are fastened to a framework element (20) allowing one or each OLED device support (4) to be fastened to a bearing structure (100).

11. The luminous panel as claimed in any one of the preceding claims, **characterized in that** the luminous joint forming means comprise a light-emitting strip (18) placed in, or at the back of, the intermediate zone ($S_7$).

12. The luminous panel as claimed in any one of claims 1 to 10, **characterized in that** the luminous joint forming means comprise scattering means (8; 28) for scattering light emitted by a light source (5; 25) toward the front of the intermediate zone ($S_7$).

13. The luminous panel as claimed in claim 12, **characterized in that** the light source comprises at least one of the two OLED devices (5), the scattering means comprising a redirecting element (8; 44) for redirecting the light emitted by said OLED device (5) toward the front of the intermediate zone ($S_7$).

14. The luminous panel as claimed in claim 13, **characterized in that** the redirecting element (8; 44) comprises at least one reflective surface (82, 83) positioned, at the back of the intermediate zone ($S_7$), facing one edge (51) of said OLED device (5).

15. The luminous panel as claimed in claim 14, **characterized in that** the redirecting element (8) is a prism placed at the back of the intermediate zone ($S_7$) between two adjacent edges (51) of the two juxtaposed OLED devices (5), a first reflective surface (82) of the prism facing the edge (51) of one of the two OLED devices whereas a second reflective surface (83) of the prism faces the edge (51) of the other OLED device.

16. The luminous panel as claimed in claim 14, **characterized in that** the redirecting element is a machined portion (44) of a support (4) of at least one of the two OLED devices (5), this machined portion (44) forming the reflective surface.

17. The luminous panel as claimed in claim 12, **characterized in that** the light source is an external source (25) coupled to the edge face of a scattering plate (28), the scattering plate (28) being placed in or at the back of the intermediate zone ($S_7$), a main face (283) of the scattering plate oriented toward the front of the intermediate zone being able to extract at least some of the light emitted by the external light source (25).

18. The luminous panel as claimed in claim 17, **characterized in that** the scattering plate (28) comprises, on one (281) of its main faces, a pattern for extracting light emitted by the external light source (25), especially a screen-printed extracting pattern.

19. A building wall, especially an internal wall or a ceiling, **characterized in that** it comprises a luminous panel as claimed in any one of the preceding claims.

Fig.1

Fig.2

**Fig.3**

**Fig.4**

**Fig.5**

Fig.6

Fig.7

Fig.8

**Fig.9**

**Fig.10**

**Fig.11**

# Fig.12

# Fig.13

**EP 2 820 347 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- EP 1534049 A2
- WO 2009087585 A1
- EP 1596638 A1

### Littérature non-brevet citée dans la description

- **MAC ADAM.** *J.Opt.Soc.Am.,* 1942, vol. 32, 247-274
- *J.Opt.Soc.Am.,* 1949, vol. 39, 808-834